# EUROPEAN PATENT APPLICATION

(11) **EP 4 804 353 A1**
(43) Date of publication of application: **09.09.2026**
(21) Application number: 26162591.7
(22) Date of filing: 05.03.2026
(51) Int. Cl.: H02B 1/056, H02B 1/56, H01H 33/59

(54) **SPACER FOR FRONT ACCESS CIRCUIT BREAKERS**

(30) Priority: 06.03.2025 IN 202511020256
(71) Applicant: Vertiv Corporation, Westerville, OH 43082 (US)
(72) Inventor: Vichare, Omkar, Westerville, 43082 (US); Jethva, Kishan Jaysukh-bhai, Westerville, 43082 (US)
(74) Representative: Ambroz, Simon

(57) **Abstract**

The present disclosure relates to a spacer for circuit breaker. The spacer **300** for a circuit breaker, comprising a cuboidal enclosure having a plurality of surfaces **301, 302, 303, 304, 305, 306** forming a space for mounting over a top of the circuit breaker with one or more adjacent circuit breakers. The plurality of surfaces includes a first surface **301** having a plurality of cutouts for dissipation of heat from the circuit breaker, a second surface **302** having an open slot for allowing connection of wires. Further, a third open surface **303** and a fourth open surface **304** is provided which forms the space within the enclosure for mounting over the top of the circuit breaker. Further, a fifth surface **305** and a sixth surface **306** is provided which are opposite to each other and having a thickness to provide an air gap with the one or more adjacent circuit breakers.

## Description

### TECHNICAL FIELD

The present disclosure generally relates to circuit breaker spacers in power systems. More specifically, the present disclosure relates to a spacer mountable on front access circuit breakers providing heat dissipation and acts as a supporting member for the circuit breakers in shelfs of the power systems.

### BACKGROUND

The subject matter discussed in the background section should not be assumed to be prior art merely as a result of its mention in the background section. Similarly, a problem mentioned in the background section or associated with the subject matter of the background section should not be assumed to have been previously recognized in the prior art.

Circuit breakers are essential components in electrical systems, providing protection by interrupting electrical flow during faults or short circuit scenarios. Typically, in a direct current (DC) power system panels, multiple circuit breakers are arranged adjacent to one another in a shelf. Typically, existing DC power system are fitted with fixed size of circuit breakers which are separated by spacers mounted on metal sheets of the shelf. In the state of the art, spacers are used between the circuit breakers which are made from insulating materials and these spacers serves the purpose of keeping the circuit breakers separated from each other and at the same time, insulating electrical contacts.

However, existing spacers may not effectively address the problem of accommodating different sizes of circuit breakers. Fixed mounting of front Access circuit breakers in DC power system cause issues leading to restricted breaker sizes. Further, existing spacers engaged with the circuit breakers have chances of deformation due to exposure to bus bar heat. Further, existing spacers are not firmly fixed on base metal sheet resulting in instability of breakers in DC power system. Therefore, under certain conditions such as high currents, the spacers themselves may become a point of failure. The heat generated by the passage of current can cause the spacers to degrade or lose their insulating properties, potentially leading to short circuits, or even failure of the circuit breaker assembly.

Therefore, a universal spacing solution is needed to allow different sizes of breakers and reduce complexity. Given the above-mentioned challenges and the limitations of current solutions, there is a need for a spacer which provides both ease of installation, improved heat dissipation and act as supporting member for circuit breakers in the shelf.

### SUMMARY OF THE INVENTION

This summary is provided to introduce aspects related to a spacer for front access circuit breakers in power systems and the aspects are further described below in the detailed description. This summary is not intended to identify essential features of the present subject matter nor is it intended for use in determining or limiting the scope of the present subject matter.

In an example of the present invention, a spacer for circuit breaker is disclosed. The spacer for a circuit breaker comprises a cuboidal enclosure having a plurality of surfaces forming an open space for mounting over a top of front access circuit breaker with one or more adjacent circuit breakers. The plurality of surfaces includes a first surface having a plurality of cutouts for dissipation of heat from the circuit breaker, a second surface having an open slot for allowing connection of wires, a third surface and a fourth surface forming the open space within the enclosure for mounting over the top of the front access circuit breaker. Further, a fifth surface and a sixth surface are provided which are opposite to each other and having a thickness to provide an air gap with the one or more adjacent circuit breakers.

In an example of the present invention, the spacer is made of polycarbonate material.

In an example, the enclosure formed by the plurality of surfaces of the spacer is cuboidal in shape.

In an example, the plurality of cut outs on the first surface is selected from any one of hexagonal perforations, circular perforations, square perforations, rectangular perforations, or triangular perforations.

In one example, the spacer is mounted on the alternate circuit breakers in a row.

In an example, the width of the fifth surface and the sixth surface is 3 mm respectively.

In another example, the fifth surface and the sixth surface of the spacer provides a gap of 3mm between the adjacent circuit breakers.

In yet another example, the spacer is formed from an electrically insulating plastic material.

In an example, the first surface of the spacer acts as supporting member for a top shelf.

In yet another example, the length and width of the surfaces of the spacer vary depending upon the size of the circuit breaker upon which the spacer would be mounted.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG 1** illustrates state of the art mounting of circuit breakers in DC power system, according to the prior art;
**FIG 2** illustrates a sectional view of the sheet metal cutout for installation of state of the spacers, according to the prior art;
**FIG 3** illustrates a perspective view of a spacer mountable on the circuit breakers;
**FIG 4** illustrates a perspective view of the spacer mounted on the circuit breaker;
**FIG 5** illustrates front view of series of circuit breakers installed within the DC power system with mounted spacer; and
**FIG 6** illustrates front view of series of circuit breakers in the DC power system with presence of gap between the top and bottom shelf.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DETAILED DESCRIPTION OF THE INVENTION

Illustrative examples are described with reference to the accompanying drawings. Wherever convenient, the same reference numbers are used throughout the drawings to refer to the same or like parts. example

Circuit breakers are primary components in Alternate current (AC) and direct current (DC) power systems and protects from sudden surge in current or short circuit. In a typical scenario, the DC power system panel have predetermined way of accommodating circuit breakers and a spacer is arranged between the circuit breaker for insulation purpose.

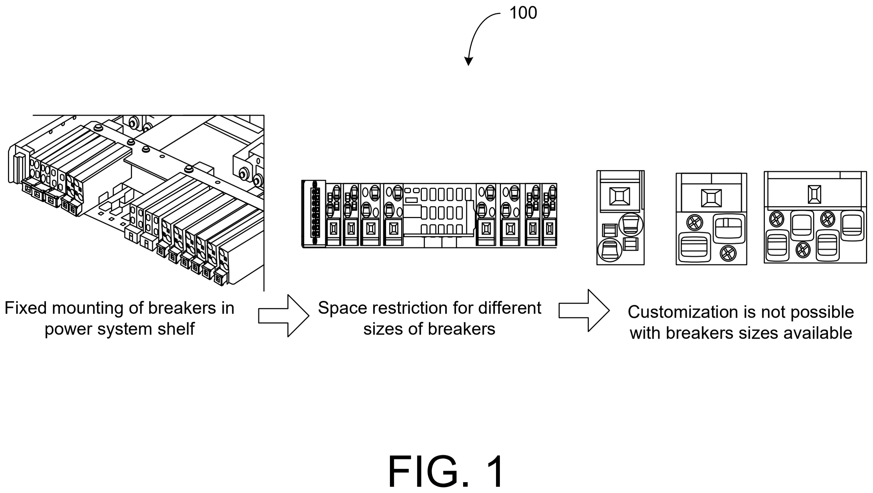

**FIG 1** illustrates state of the art mounting of circuit breakers in DC power system, according to the prior art. As illustrated, one drawback associated with current DC power system is that the system uses different types of circuit breaker according to their Ampere rating. Permanent Placement of this circuit breakers in system makes manufacturing more complex and a customer may not able to use different sizes of breakers. For example, if the customer requires 63Apms of circuit breaker instead of 125Amps breaker, with permanent placement this will be impossible to change as sizes are different. The existing spacers does not support changing the circuit breaker sizes. Existing spacers may not effectively address of problem of accommodating different sizes of breakers.

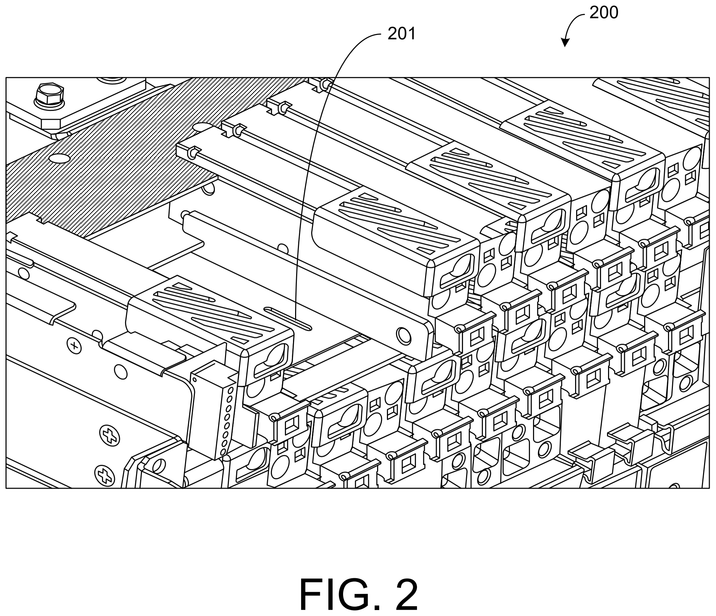

**FIG 2** illustrates a sectional view of the shelf with sheet metal cutout for installation of conventional spacers, according to the prior art. Existing spacers are engaged with shelf via sheet metal cutout and such spacers are prone to deformation or damage due to bus bar heat exposure. Further, existing spacers are not firmly fixed on base resulting instability of breakers in DC power system. Further, providing metal cutouts also weakens the strength of metal sheet of the shelf.

Therefore, the present invention provides an improved spacer for circuit breakers which achieves multiple purposes for example, proper alignment of circuit breakers, different size of spacers for different circuit breaker size thereby enabling accommodation of circuit breakers of different sizes yet aligned in tight arrangements with appropriate air gap for ventilation.

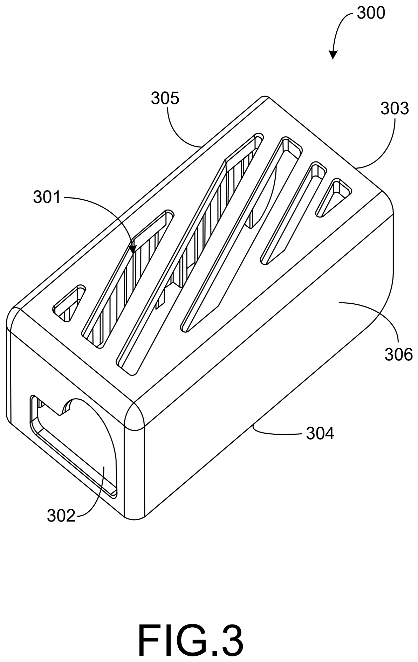

**FIG 3** illustrates a perspective view of a spacer **300** mountable on the circuit breakers. The spacer **300** for the circuit breaker comprises an enclosure having a plurality of surfaces **301, 302, 303, 304, 305, 306** forming an open space for mounting over a top of the circuit breaker. The length and width of the surfaces **301, 302, 303, 304, 305, 306** may vary depending upon the size of the circuit breaker upon which the spacer would be mounted or fitted. In an example, the enclosure formed by the plurality of surfaces **301, 302, 303, 304, 305** and **306** is cuboidal in shape. The spacer when mounted over circuit breaker, the inner side of surfaces **301, 302, 305, 306** are in close contact with the circuit breaker.

In the plurality of surfaces, the surface **301** may be referred to as a first surface, the surface **302** may be referred to as a second surface. The surface **303, 304** may be referred to as a third open surface and a fourth open surface respectively. The surface **305, 306** may be referred to as a fifth surface **305** and a sixth surface **306** respectively.

In an example, the third open surface **303** and the fourth open surface **304** forms a space within the enclosure for mounting over the top of the circuit breaker. In another example, the first surface **301** of the spacer has plurality of cutouts which helps dissipation of heat, when the spacer is mounted on the circuit breaker. In an example, the plurality of cutouts on the first surface **301** is selected from any one of hexagonal perforations, circular perforations, square perforations, rectangular perforations, or triangular perforations. Further, the first surface **301** of the spacer acts as supporting member for a top shelf.

In yet another example, the second surface **302** has an open slot for allowing connection of wires to the circuit breakers. In an example, the fifth surface **305** and the sixth surface **306** are opposite to each other and has a thickness for providing an air gap with the one or more adjacent circuit breakers. In an example, the width of the fifth surface **305** and the sixth surface **306** is in the range of 1-3 mm respectively. When the spacer is mounted on the alternate circuit breakers in a row, the fifth surface **305** and a sixth surface **306** of the spacer provides a gap of in the range of 1-3mm between the adjacent circuit breakers. In a preferred example, the width of fifth surface **305** and the sixth surface **306** is 3mm, thereby providing a gap of 3mm between the adjacent circuit breakers.

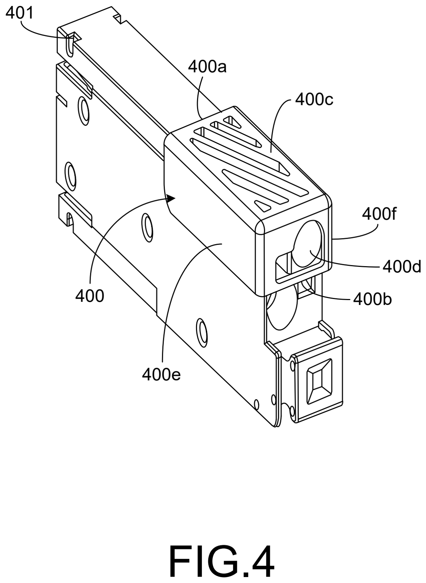

In an example, the spacer is formed from an electrically insulating plastic material, for example, polycarbonate which is resistant to heat. A more detailed examples of spacer mounted on the circuit breaker is illustrated in reference to **FIG 4****.**

**Fig. 4** illustrates a perspective view of a circuit breaker **401** mounted with a spacer **400,** according to an exemplary example. In an example, the spacer **400** is a cuboidal enclosure with open surfaces **400a** and **400b,** which enables a user or customer to detachably mount the spacer **400** over top of a circuit breaker **401.** In an example, the circuit breakers are front access circuit breakers and the spacer is slid over the circuit breaker **401** through the open surfaces **400a** and **400b.** In another example, the circuit breaker may be removed from the power system panel, the spacer **400** is mounted on the circuit breaker **401** through the open surfaces **400a** and **400b.** Once the spacer **400** is rigidly mounted on the circuit breaker **401,** the circuit breaker is placed back on the power system panel.

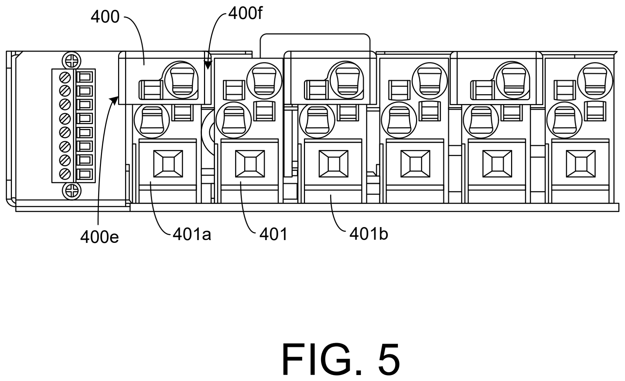

In an example, surfaces **400c, 400d, 400e** and **400f** are in close contact with the circuit breaker. It is necessary to have mechanism to dissipate heat from the circuit breakers and the spacer **400** provides provision for dissipation of heat through plurality of cut-outs on the surface **400c.** The cutouts on the surface **400c** helps dissipation of heat from the surface of the circuit breaker **401.** As the circuit breaker, in an example, is a front access breaker, the surface **400d** of the spacer **400** provides an opening for connection of wires with the circuit breakers. The opening on the surface **400d** provides the ease of changing or fixing the wiring on the circuit breaker. In a further example, the surface **400e** and **400f** has a predetermined thickness which helps in providing an air gap with the alternative circuit breakers, examples of which are illustrated with reference to Fig. 5.

**Fig 5** illustrates a front view of series of circuit breakers installed within the DC power system with mounted spacer, according to an example of the present invention. In a power system panel, such as DC power system panels, number of circuit breakers **401, 401a, 401b** are arranged in series, in a tight arrangement. According to the present invention, the spacer **400** is mounted on alternate circuit breakers. As mentioned above, the surfaces **400e, 400f** of the spacer **400** have a predetermined thickness, which helps in providing an air gap (*for example 3mm gap*) with the side surface of alternative circuit breakers on both sides. The air gap helps in dissipation of heat from the power panels, resulting in increased efficiency in thermal management in panels without any additional components. In an example, the circuit breakers are front access circuit breakers and the spacer **400** is slid over the circuit breaker **401** through the open surfaces **400a** and **400b.** In another example, the circuit breaker may be removed from the power system panel, the spacer **400** is mounted on the circuit breaker **401** through the open surfaces **400a** and **400b.** Once the spacer **400** is rigidly mounted on the circuit breaker **401,** the circuit breaker is placed back on the power system panel in a tight arrangement with other circuit breakers.

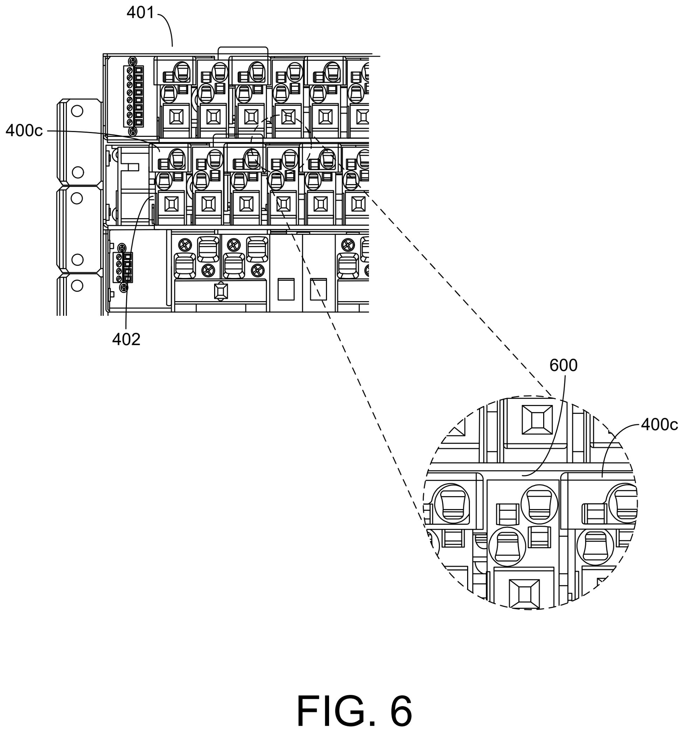

**Fig. 6** illustrates front view of shelf with series of circuit breakers arranged in the DC power system with presence of gap between the top and bottom shelf, according to another example of the present invention. In an example, series of circuit breakers **401, 402** may be arranged in top and bottom shelfs. As illustrated, the spacers are arranged on alternate circuit breakers, wherein the surface **400c** provides contact with the upper shelf. In an example, the material of the spacer is made up of polycarbonate materials making it resistant to heat. This arrangement provides an advantage wherein the surface **400c** has a thickness which provides air gap **600** between the upper shelf surface and top surface of the alternate circuit breaker (*without spacer*)*.* This feature provides further air ventilation to heat dissipation thereby creating the thermal efficiency of the power systems.

The present invention provides a spacer which is mountable on the circuit breakers and provides structural stability to the breaker within the shelf. Further, the surfaces of the spacers provide enhanced heat dissipation thereby improve thermal management of the DC panels. Further, a spacer's size is variable enables mounting of circuit breakers of different sizes without making changes to the shelf structure.

The systems, devices discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different aspects and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

Described herein are the following clauses:
1. A spacer (300) for a circuit breaker, comprising: an enclosure having a plurality of surfaces (301, 302, 303, 304, 305, 306) forming a space for mounting over a top of the circuit breaker with one or more adjacent circuit breakers, wherein the plurality of surfaces includes: a first surface (301) having a plurality of cutouts for dissipation of heat from the circuit breaker; a second surface (302) having an open slot for allowing connection of wires; a third open surface (303) and a fourth open surface (304) forming the space within the enclosure for mounting over the top of the circuit breaker; and a fifth surface (305) and a sixth surface (306), wherein the fifth and sixth surface are opposite to each other and having a thickness to provide an air gap with the one or more adjacent circuit breakers.
2. The spacer (300) of clause 1, wherein the enclosure formed by the plurality of surfaces (301, 302, 303, 304, 305 and, 306) is cuboidal in shape.
3. The spacer (300) of any one of the preceding clauses, wherein the plurality of cutouts on the first surface (301) is selected from any one of hexagonal perforations, circular perforations, square perforations, rectangular perforations, or triangular perforations.
4. The spacer (300) of any one of the preceding clauses, wherein the spacer is mounted on the alternate circuit breakers in a row.
5. The spacer (300) of clause 4, wherein the width of the fifth surface (305) and the sixth surface (306) is 3 mm respectively.
6. The spacer (300) of clause 5, wherein the fifth surface (305) and a sixth surface (306) of the spacer provides a gap of 3mm between the adjacent circuit breakers.
7. The spacer (300) of any preceding clause, wherein the spacer is formed from an electrically insulating plastic material.
8. The spacer (300) of any preceding clause, wherein the first surface (301) of the spacer acts as supporting member for a top shelf.
9. The spacer (300) of any preceding clause, wherein length and width of the surfaces (301, 302, 303, 304, 305, 306) vary depending upon the size of the circuit breaker upon which the spacer would be mounted.
10. The spacer (300) of any preceding clause, wherein the inner surfaces (301, 302, 305, 306) are in close contact with the circuit breaker.

## Claims

1. A spacer (300) for a circuit breaker, comprising:
an enclosure having a plurality of surfaces (301, 302, 303, 304, 305, 306) forming a space for mounting over a top of the circuit breaker with one or more adjacent circuit breakers, wherein the plurality of surfaces includes:
a first surface (301) having a plurality of cutouts for dissipation of heat from the circuit breaker;
a second surface (302) having an open slot for allowing connection of wires;
a third open surface (303) and a fourth open surface (304) forming the space within the enclosure for mounting over the top of the circuit breaker; and
a fifth surface (305) and a sixth surface (306), wherein the fifth and sixth surface are opposite to each other and having a thickness to provide an air gap with the one or more adjacent circuit breakers.

2. The spacer (300) of claim 1, wherein the enclosure formed by the plurality of surfaces (301, 302, 303, 304, 305, 306) is cuboidal in shape.

3. The spacer (300) of any one of the preceding claims, wherein the plurality of cutouts on the first surface (301) is selected from any one of hexagonal perforations, circular perforations, square perforations, rectangular perforations, or triangular perforations.

4. The spacer (300) of any one of the preceding claims, wherein the spacer is mounted on the alternate circuit breakers in a row.

5. The spacer (300) of claim 4, wherein the width of the fifth surface (305) and the sixth surface (306) is 3 mm respectively.

6. The spacer (300) of claim 5, wherein the fifth surface (305) and a sixth surface (306) of the spacer provides a gap of 3mm between the adjacent circuit breakers.

7. The spacer (300) of any one of the preceding claims, wherein the spacer is formed from an electrically insulating plastic material.

8. The spacer (300) of any one of the preceding claims, wherein the first surface (301) of the spacer acts as supporting member for a top shelf.

9. The spacer (300) of any one of the preceding claims, wherein length and width of the surfaces (301, 302, 303, 304, 305, 306) vary depending upon the size of the circuit breaker upon which the spacer would be mounted.

10. The spacer (300) of any one of the preceding claims, wherein the inner surfaces (301, 302, 305, 306) are in close contact with the circuit breaker.

11. A system comprising:
a circuit breaker; and
the spacer according to any one of the preceding claims.

12. The system of claim 11, wherein the spacer is detachably mountable over the circuit breaker.

13. The system of any one of the claims 11 to 12, further comprising a shelf for the circuit breaker.
